# EUROPÄISCHE PATENTANMELDUNG

(11) **EP 4 800 406 A1**
(43) Veröffentlichungstag der Anmeldung: **02.09.2026**
(21) Anmeldenummer: 25160942.6
(22) Anmeldetag: 28.02.2025
(51) Int. Cl.: G01R 31/389, G01R 31/392

(54) **ERMITTLUNG EINES KRITISCHEN BATTERIEMODULS SOWIE DESSEN VERWENDUNG, COMPUTERPROGRAMMPRODUKT**

(71) Anmelder: Siemens Aktiengesellschaft, 80333 München (DE)
(72) Erfinder: Fischer, Michael, 91320 Ebermannstadt (DE); Chan, Hoon Seng, 91052 Erlangen (DE); Radinger, Hannes, 86152 Augsburg (DE); Schricker, Barbara, 91058 Erlangen (DE)
(74) Vertreter: Siemens Patent Attorneys

(57) **Zusammenfassung**

Es wird ein Verfahren zur Ermittlung eines kritischen Batteriemoduls (1) vorgeschlagen, wobei das Batteriemodul (1) kritisch ist, wenn es mindestens eine Batteriezelle mit einem Gesundheitszustand kleiner oder gleich einem festgelegten Schwellenwert umfasst. Das Verfahren ist gekennzeichnet durch folgende Schritte:
- (101) Erfassen eines Impedanzspektrums des Batteriemoduls mittels einer Impedanzspektroskopie;
- (102) Ermitteln eines DRT-Verlaufs (208) mittels eines Verfahrens der verteilten Relaxationszeitkonstanten basierend auf dem erfassten Impedanzspektrum;
- (103) Ermitteln des Batteriemoduls (1) als kritisch, wenn der ermittelte DRT-Verlauf (208) einen festgelegten Toleranzbereich (2) verletzt.

Weiterhin betrifft die Erfindung eine Verwendung eines Batteriemoduls in Abhängigkeit seiner Kritikalität sowie ein Computerprogrammprodukt.

## Beschreibung

Die vorliegende Erfindung betrifft eine Analyse von Batteriemodulen und insbesondere ein Verfahren zur Ermittlung eines kritischen Batteriemoduls gemäß Anspruch 1, eine Verwendung eines Batteriemoduls gemäß Anspruch 8 sowie ein Computerprogrammprodukt gemäß Anspruch 10.

Der Bereich der Batterietechnologie hat in den letzten Jahren, insbesondere angetrieben durch die steigende Nachfrage nach effizienten und zuverlässigen Energiespeicherlösungen, an Bedeutung gewonnen. Batteriespeicher beziehungsweise Batterien sind für verschiedenste Anwendungen relevant, von tragbaren elektronischen Geräten über Elektrofahrzeuge bis hin zu großen Energiespeichersystemen. Mit der zunehmenden Abhängigkeit von batteriebetriebenen Geräten und Systemen wächst die Bedeutung einer möglichst genauen Bewertung der Batteriegesundheit und der Batterieleistung.

Batteriemodule, die mehrere einzelne Batteriezellen beziehungsweise Zellen umfassen, wobei die Zellen in Reihen- und/oder Parallelschaltung verbunden sind, werden typischerweise verwendet, um die Leistungs- und Energieanforderungen verschiedener Anwendungen zu erfüllen. Diese Module bieten Vorteile in Bezug auf Skalierbarkeit, Flexibilität und Gesamtsystemleistung. Die Komplexität von Batteriemodulen stellt jedoch Herausforderungen in Bezug auf die Überwachung und Aufrechterhaltung ihrer Gesundheit (englisch: State of Health, SOH) und Effizienz im Laufe der Zeit dar.

Ein wichtiger Aspekt des Batteriemodulmanagements ist die Möglichkeit, den Gesundheitszustand (SOH) einzelner Zellen innerhalb des Moduls zu ermitteln. Der SOH ist ein Maß für den Zustand einer Batterie im Verhältnis zu ihrer idealen beziehungsweise Anfangskapazität und wird typischerweise als Prozentsatz angegeben. Mit zunehmendem Alter und/oder wiederholten Lade-Entlade-Zyklen kann sich die Leistung von Batterien verschlechtern, was zu einer verringerten Kapazität und einem erhöhten Innenwiderstand führt. Diese Verschlechterung tritt möglicherweise nicht gleichmäßig über alle Zellen in einem Modul auf, was es entscheidend macht, leistungsschwache oder "kritische" Zellen zu identifizieren, da diese kritischen Zellen die Gesamtleistung des Moduls negativ beeinflussen können.

Typische Verfahren zur Bewertung der Batteriegesundheit beruhen auf direkten Messungen der Spannungen einzelner Zellen, was in großen Batteriemodulen ohne Zugang zu internen Verbindungen eine Herausforderung darstellt. Weiterhin bieten diese Methoden möglicherweise kein umfassendes Verständnis des dynamischen Verhaltens von Zellen unter verschiedenen Betriebsbedingungen. Somit besteht ein wachsender Bedarf an nicht-invasiven Techniken, die den Gesundheitszustand einzelner Zellen innerhalb eines Batteriemoduls ermitteln können, ohne einen direkten Zugang zu jeder Zelle zu erfordern.

Der vorliegenden Erfindung liegt die Aufgabe zugrunde, eine Ermittlung kritischer Batteriemodule, die Zellen mit verschlechtertem Gesundheitszustand umfassen, insbesondere ohne direkten Zugang zu einzelnen Zellen, zu ermöglichen.

Die Aufgabe wird durch ein Verfahren mit den Merkmalen des unabhängigen Anspruchs 1, durch eine Verwendung mit den Merkmalen des unabhängigen Anspruchs 9 sowie durch ein Computerprogrammprodukt mit den Merkmalen des unabhängigen Anspruchs 10 gelöst. In den abhängigen Patentansprüchen sind vorteilhafte Ausgestaltungen und Weiterbildungen der Erfindung angegeben.

Das erfindungsgemäße Verfahren zur Ermittlung eines kritischen Batteriemoduls, wobei das Batteriemodul kritisch ist, wenn es mindestens eine Batteriezelle mit einem Gesundheitszustand (SOH) kleiner oder gleich einem festgelegten Schwellenwert umfasst, ist gekennzeichnet durch folgende Schritte:
- Erfassen eines Impedanzspektrums des Batteriemoduls mittels einer Impedanzspektroskopie;
- Ermitteln eines DRT-Verlaufs mittels eines Verfahrens der verteilten Relaxationszeitkonstanten basierend auf dem erfassten Impedanzspektrum;
- Ermitteln des Batteriemoduls als kritisch, wenn der ermittelte DRT-Verlauf einen festgelegten Toleranzbereich verletzt.

Ein Batteriemodul ist typischerweise eine Anordnung mehrerer Batteriezellen, die elektrisch in Reihen- und/oder Parallelschaltung verbunden sind, beispielsweise um eine gewünschte Spannung und/oder Kapazität bereitzustellen. Ein Batteriemodul kann zusätzliche Komponenten, wie beispielsweise Sensoren, Steuerungselektronik und/oder Thermomanagementsysteme, umfassen.

Ein kritisches Batteriemodul ist ein Batteriemodul, das mindestens eine Batteriezelle mit einem Gesundheitszustand kleiner oder gleich dem festgelegten Schwellenwert umfasst. Eine Zelle mit einem solchen Gesundheitszustand kann als kritische Zelle bezeichnet werden. Ein nicht-kritisches Batteriemodul ist ein Batteriemodul, welches nur Zellen umfasst, deren jeweiliger Gesundheitszustand größer als der festgelegte Schwellenwert ist. Der Begriff der Kritikalität des Batteriemoduls bezieht sich darauf, ob das Batteriemodul eine oder mehrere kritische Zellen oder keine kritischen Zellen umfasst. Typischerweise weist die Kritikalität eines Batteriemoduls auf potenzielle Leistungsprobleme und/oder Sicherheitsprobleme hin.

Das Ermitteln eines kritischen Batteriemoduls kann ebenfalls als Bewertung des Batteriemoduls bezüglich seiner Kritikalität und/oder als Verfahren zur Erkennung von kritischen Batteriemodulen aufgefasst werden.

Ein Gesundheitszustand einer Batteriezelle bezieht sich typischerweise auf ein Maß für ihren aktuellen Zustand im Verhältnis zu ihrem idealen und/oder anfänglichen Zustand. Er wird typischerweise als Prozentsatz ausgedrückt und kann abhängig von Faktoren, wie beispielsweise Kapazitätserhaltung, Innenwiderstand und/oder allgemeine Leistungsverschlechterung im Laufe der Zeit sein.

Eine Impedanzspektroskopie ist eine nicht-invasive elektrochemische Messtechnik, die ein Wechselstrom- und/oder Spannungssignal über einen Frequenzbereich an eine Batterie anlegt und das resultierende Impedanzspektrum erfasst. Diese Methode stellt Informationen über verschiedene elektrochemische Prozesse innerhalb der Batterie beziehungsweise des Batteriemoduls bereit.

Ein Impedanzspektrum ist das Ergebnis einer Impedanzspektroskopie. Hierbei sind die Messwerte der Impedanzspektroskopie von der Frequenz des angelegten Wechselstrombeziehungsweise Spannungssignals abhängig. Mittels des Impedanzspektrums können die elektrischen Reaktionscharakteristiken innerhalb Batterie über verschiedene Zeitskalen der elektrochemischen Prozesse charakterisiert werden.

Ein DRT-Verlauf ist eine Verteilung der Relaxationszeiten (englisch: Distribution of Relaxation Times, DRT), die aus dem Impedanzspektrum unter Verwendung eines Verfahrens der verteilten Relaxationszeitkonstanten ermittelt wird. Eine DRT beziehungsweise ein DRT-Verfahren ist somit eine Analysemethode, die Impedanzdaten (Impedanzspektrum) verwendet, um die Prozesse mit ihren Zeitkonstanten innerhalb der Batterie verbessert zu trennen (aufzulösen) und zu identifizieren. Hierzu wird eine frequenzabhängige Verteilung der Zeitkonstanten ermittelt.

Ein Toleranzbereich ist ein vorab festgelegter Bereich von technisch akzeptablen DRT-Verläufen. Er kann durch eine obere und untere Kennlinie definiert beziehungsweise begrenzt sein. Der Toleranzbereich wird verwendet, um zu ermitteln, ob ein Batteriemodul kritisch oder nicht-kritisch ist.

Die Erfindung weist wenigstens einen oder mehrere der folgenden Vorteile auf:
Nicht-invasive Bewertung: Das Verfahren kann ohne einen direkten Zugang zu den einzelnen Zellen des Batteriemoduls durchgeführt werden. Dadurch ermöglicht die Erfindung die Bewertung des Zellzustands, ohne das Modul zu zerlegen und/oder physisch auf die internen Komponenten zuzugreifen. Dieser nicht-invasive Ansatz reduziert den Zeit- und Kostenaufwand sowie potenzielle Risiken bei der Batteriediagnose.

Unabhängigkeit von Batteriemanagementsystem (BMS)-Daten: Im Gegensatz zu Methoden, die auf Daten des Batteriemanagementsystems angewiesen sind, kann die Erfindung für jedes Batteriemodul verwendet werden, ohne einen Zugang zu proprietären BMS-Informationen oder Kommunikationsprotokollen zu erfordern.

Erkennung von Einzelzellendegradation: Die Erfindung ist in der Lage das Vorhandensein einer oder mehrerer degradierter Zellen (kritische Zellen) innerhalb eines Batteriemoduls zu identifizieren. Dies ist besonders vorteilhaft für in Reihe geschaltete Zellen, bei denen eine einzelne leistungsschwache Zelle die Gesamtleistung des Moduls erheblich beeinflussen kann. Bekannte Verfahren, die lediglich die Gesamteigenschaften des Moduls messen, können solche lokalisierten Degradationen übersehen beziehungsweise nicht zellspezifisch auflösen.

Zeiteffiziente Analyse: Durch die Verwendung einer Impedanzspektroskopie und der Analyse der Verteilung von Relaxationszeiten (DRT) kann das Verfahren den Zustand des Batteriemoduls effizient und schnell ermitteln, ohne dass langfristige Zyklisierungstests oder Kapazitätstests durchgeführt werden müssen. Dies ermöglicht ein schnelles Screening von Batteriemodulen in verschiedenen Anwendungen, wie beispielsweise einer Qualitätskontrolle in der Fertigung und/oder bei einer Diagnostik in Servicezentren.

Sensitivität für verschiedene Degradationsmechanismen: Die DRT-Analyse liefert Einblicke in verschiedene elektrochemische Prozesse innerhalb der Batteriezellen. Dies ermöglicht es dem Verfahren zwischen verschiedenen Arten von Degradationsmechanismen zu unterscheiden, wie beispielsweise einem Verlust von aktivem Material, einem erhöhter Innenwiderstand und/oder einer Veränderung der Elektrodenkinetik.

Anpassungsfähigkeit an verschiedene Batterietypen: Das Verfahren kann für verschiedene Batteriechemien und/oder -konfigurationen verwendet werden. Insbesondere ohne spezifische Informationen über die interne Zellstruktur und/oder -chemie zu erfordern. Diese Vielseitigkeit macht das Verfahren für ein breites Spektrum von Anwendungen geeignet.

Früherkennung potenzieller Probleme: Durch die Identifizierung kritischer Batteriemodule, bevor sie signifikante Leistungsbeeinträchtigungen oder Sicherheitsbedenken verursachen, ermöglicht das Verfahren proaktive Wartungs- und Austauschstrategien. Dies kann zu einer verbesserten Gesamtsystemzuverlässigkeit und Langlebigkeit führen, insbesondere in Anwendungen, bei denen ein Batterieausfall schwerwiegende Folgen haben könnte.

Optimierung des Batterie-Lebenszyklus-Managements: Durch die Identifizierung kritischer Module ermöglicht die Methode effizientere und technisch basierte Entscheidungen bezüglich der Wiederverwendung, Wiederaufbereitung oder des Recyclings von Batterien. Dies trägt zu einer verbesserten Ressourcennutzung bei und unterstützt ein nachhaltiges Batteriemanagement.

Erhöhte Sicherheit: Die frühzeitige Erkennung kritischer Batteriemodule kann potenzielle Sicherheitsrisiken verhindern, die mit stark degradierten Zellen verbunden sind, wie beispielsweise thermisches Durchgehen und/oder unerwartete Ausfälle während des Betriebs. Dies ist besonders wichtig bei Hochleistungsanwendungen, wie beispielsweise Elektrofahrzeugen und/oder Speichersysteme für Stromnetze.

Skalierbarkeit: Das Verfahren ist von kleinen Batteriemodulen bis hin zu großen Batteriesystemen verwendbar. Dadurch ist das Verfahren für ein breites Spektrum von Anwendungen geeignet, von Unterhaltungselektronik bis zur industriellen Energiespeicherung.

Reduzierte Abhängigkeit von umfangreichen historischen Daten: Im Gegensatz zu maschinellen Lernansätzen, die große Datensätze der Batterieleistungshistorie erfordern, stützt sich diese Methode auf grundlegende elektrochemische Prinzipien und kann mit einem begrenzteren Satz von Referenzdaten effektiv sein.

Integration in bestehende Systeme: Das Verfahren kann in bestehende Batteriemanagementsysteme (BMS), Energiemanagementsysteme (EMS) und/oder Qualitätskontrollprozesse integriert werden und erweitert deren Fähigkeiten, ohne signifikante Änderungen an etablierten Arbeitsabläufen zu erfordern.

Datengestützte Erkenntnisse: Die Analyse liefert wertvolle Daten, die zur Erstellung genauerer Modelle der Batteriealterung und Leistungsverschlechterung im Laufe der Zeit verwendet werden können. Dies kann zukünftige Batteriedesigns beeinflussen und die Gesamtzuverlässigkeit des Systems verbessern.

Kosteneffektive Implementierung: Das Verfahren kann mittels einfacher und bekannter elektrischer Messgeräte und Datenanalysetechniken implementiert werden. Dadurch stellt das Verfahren eine kosteneffektive und technisch effiziente Lösung für die Bewertung des Batteriezustands bereit.

Die erfindungsgemäße Verwendung eines Batteriemoduls, die davon abhängig ist, ob das Batteriemodul kritisch ist, wobei das Batteriemodul kritisch ist, wenn es eine oder mehrere Batteriezellen mit einem Gesundheitszustand kleiner oder gleich einem festgelegten Schwellenwert umfasst, ist dadurch gekennzeichnet, dass die Ermittlung der Kritikalität des Batteriemoduls mittels eines Verfahrens gemäß einem der Ansprüche 1 bis 7 durchgeführt wird.

Es ergeben sich zum erfindungsgemäßen Verfahren gleichartige, gleichwertige und gleichwirkende Vorteile.

Das erfindungsgemäße Computerprogrammprodukt umfasst Befehle, die, wenn sie von einer Recheneinheit, insbesondere einem Computer, ausgeführt werden, diese veranlassen, ein Verfahren und/oder Schritte des Verfahrens gemäß einem der Ansprüche 1 bis 9 auszuführen.

Es ergeben sich zum erfindungsgemäßen Verfahren gleichartige, gleichwertige und gleichwirkende Vorteile.

Gemäß einer bevorzugten Ausgestaltung der Erfindung wird ein Impedanzwert, insbesondere ein Impedanzwert oberhalb von 1 kHz, vom Impedanzspektrum subtrahiert.

Die Subtraktion eines hochfrequenten Impedanzwerts, insbesondere oberhalb von 1 kHz, ermöglicht die Eliminierung von ohmschen und induktiven Effekten aus der Analyse. Durch die Entfernung dieser Beiträge kann sich die Methode präziser auf die niederfrequenten Reaktionen konzentrieren, die auf Zelldegradation und kritische Zustände hinweisen. Dadurch erhöht sich die Sensitivität der DRT-Analyse, insbesondere im Hinblick auf eine Erkennung von Veränderungen in den elektrochemischen Prozessen innerhalb der Batteriezellen.

Gemäß einer bevorzugten Ausgestaltung der Erfindung wird der Toleranzbereich durch zwei Kennlinien begrenzt.

Mit anderen Worten wird der Toleranzbereich durch eine untere und obere Kennlinie begrenzt beziehungsweise ausgebildet. Die Definition des Toleranzbereichs mittels der Kennlinien ist besonders vorteilhaft für die Identifizierung kritischer Batteriemodule. Durch die Verwendung eines Bereichs wird die Berücksichtigung von Fertigungsschwankungen und erwarteten Degradationsmustern ermöglicht. Dadurch können falsch positive Ergebnisse im Erkennungsprozess reduziert werden. Die Kennlinien beziehungsweise der Toleranzbereich kann batteriespezifisch sein, das heißt beispielsweise an spezifische Batteriearten, Batteriechemien, Batteriedesigns und/oder Anwendungsanforderungen angepasst sein. Weiterhin kann der Toleranzbereich temperaturabhängig, ladezustandsabhängig und/oder abhängig vom Alter der Batterie sein. Der Toleranzbereich und/oder die Kennlinien können mittels Referenzmessungen für nicht-kritischen Batteriemodule bereitgestellt und festgelegt werden.

Gemäß einer bevorzugten Ausgestaltung der Erfindung umfasst das Impedanzspektrum mindestens eine oder mehrere Frequenzen im Frequenzbereich von 10⁻³ Hz bis 10⁻² Hz und/oder von 1 bis 10 Hz und/oder von 100 Hz bis 1000 Hz.

Die genannten Frequenzbereiche ermöglichen eine umfassende Analyse verschiedener elektrochemischer Prozesse, die innerhalb der Batteriezellen auftreten können. Der niedrige Frequenzbereich (10⁻³ Hz bis 10⁻² Hz) erfasst langsame Prozesse, wie beispielsweise Diffusionen, die auf eine langfristige Degradation hinweisen können. Die mittleren Frequenzen (1 bis 10 Hz) entsprechen typischerweise Ladungsübertragungsprozessen, während die höheren Frequenzen (100 Hz bis 1000 Hz) Informationen über die Elektrolytleitfähigkeit und/oder Oberflächenschichteffekte liefern können. Durch die Berücksichtigung von Messungen über die genannten Frequenzbereiche kann die Methode ein genaueres und vollständigeres Bild des Gesundheitszustands des Batteriemoduls bereitstellen.

Gemäß einer bevorzugten Ausgestaltung der Erfindung wird zur Ermittlung der Verletzung des Toleranzbereichs der DRT-Verlauf auf einen seiner Werte normiert.

Die Normierung des DRT-Verlaufs auf einen seiner Werte ermöglicht eine standardisierte Methode für den Vergleich zwischen verschiedenen Batteriemodulen und/oder Messungen. Die Normierung ermöglicht einen einfacheren Vergleich zwischen verschiedenen Batteriemodulen und/oder Messungen und reduziert den Einfluss von Schwankungen in den absoluten Impedanzwerten. Dieser Ansatz kann relative Änderungen im DRT-Verlauf hervorheben, die möglicherweise aussagekräftiger für die Zelldegradation sind als die absoluten Impedanzwerte.

Gemäß einer bevorzugten Ausgestaltung der Erfindung wird der Toleranzbereich derart festgelegt, dass dieser Fertigungstoleranzen des Batteriemoduls und/oder seiner Batteriezellen berücksichtigt.

Die Einbeziehung von Fertigungstoleranzen in die Definition des Toleranzbereichs stellt sicher, dass die Methode zwischen normalen Schwankungen in der Batterieleistung und tatsächlich kritischen Zuständen unterscheiden kann. Dieser Ansatz reduziert falsch positive Ergebnisse, die aus geringfügigen Unterschieden in den Zelleigenschaften aufgrund von Fertigungsprozessen entstehen könnten. Der Toleranzbereich könnte basierend auf einer statistischen Analyse einer Stichprobe von Batteriemodulen festgelegt werden, wobei Faktoren wie Schwankungen in der Zellkapazität, dem Innenwiderstand und/oder anderen Schlüsselparametern berücksichtigt werden können. Maschinelle Lerntechniken könnten möglicherweise verwendet werden, um die Definition des Toleranzbereichs basierend auf gesammelten Daten von verschiedenen Batteriemodulen im Laufe der Zeit zu verfeinern und/oder anzupassen.

Gemäß einer bevorzugten Ausgestaltung der Erfindung wird der Schwellenwert für den Gesundheitszustand der Batteriezellen auf einen Wert von 80 Prozent, vorzugsweise von 70 Prozent, besonders bevorzugt von 60 Prozent festgelegt.

Die Festlegung spezifischer Schwellenwerte für den Gesundheitszustand bietet objektiv nachvollziehbare Kriterien zur Ermittlung der Kritikalität von Batteriemodulen. Diese Werte können basierend auf Anwendungsanforderungen, Sicherheitsüberlegungen oder wirtschaftlichen Faktoren im Zusammenhang mit dem Batterie-Lebenszyklus-Management festgelegt werden. Alternativ oder ergänzend können mehrerer Schwellenwerte zur Kategorisierung von Batteriemodulen in verschiedene Kritikalitätsstufen und/oder adaptive Schwellenwerte verwendet werden, die sich beispielsweise basierend auf dem Alter und/oder der Nutzungshistorie des Batteriemoduls ändern.

Gemäß einer bevorzugten Ausgestaltung der Erfindung ist die Verwendung abhängig von der Anzahl der Batteriezellen mit einem Gesundheitszustand (SOH) kleiner oder gleich dem festgelegten Schwellenwert eine Wiederverwendung, eine Wiederaufarbeitung oder ein Recycling des Batteriemoduls.

Mit anderen Worten ist die Verwendung beziehungsweise die Art der weiteren Verwendung des Batteriemoduls von der Anzahl der ermittelten kritischen Batteriezellen abhängig. Dadurch wird vorteilhafterweise ein optimiertes Lebenszyklus-Management von Batteriemodulen basierend auf ihrem ermittelten Zustand möglich. Eine Wiederverwendung von Modulen mit wenigen oder keinen kritischen Zellen kann ihre Betriebsdauer in weniger anspruchsvollen Anwendungen verlängern. Eine Wiederaufbereitung, die den Austausch und/oder die Rekonditionierung einzelner Zellen umfassen kann, kann für Module mit einer begrenzten Anzahl kritischer Zellen sinnvoll sein. Recycling ist für Module mit einer hohen Anzahl kritischer Zellen bevorzugt, wobei dadurch eine ordnungsgemäße Materialrückgewinnung und Entsorgung sichergestellt wird.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
- Figur 1: ein Blockdiagramm eines Systems zur Ermittlung der Verwendung eines Batteriemoduls; und
- Figur 2: ein Diagramm, das eine Analyse der Verteilung von Relaxationszeiten (DRT) für Batteriemodule zeigt.

Gleichartige, gleichwertige oder gleichwirkende Elemente können in einer der Figuren oder in den Figuren mit denselben Bezugszeichen versehen sein.

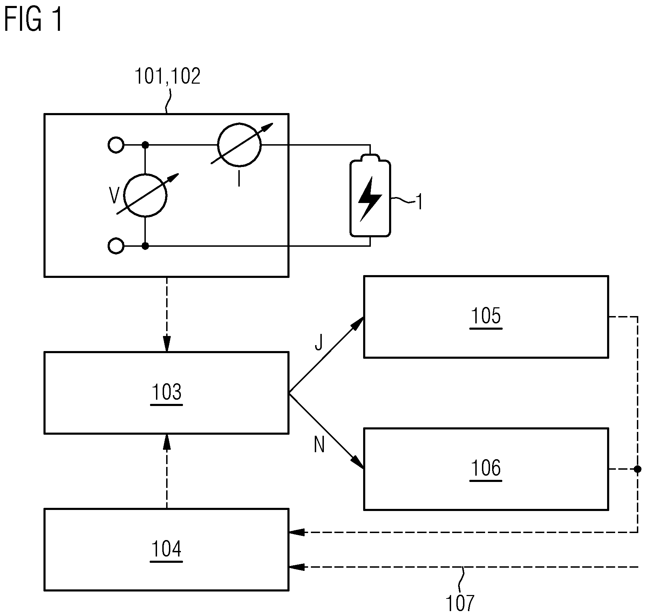

Die Figur 1 zeigt ein Blockdiagramm eines Systems zur Ermittlung der Kritikalität und der Verwendung eines Batteriemoduls 1. Das System umfasst mehrere miteinander verbundene Komponenten und Prozesse, die zusammenwirken, um den Gesundheitszustand eines Batteriemoduls beziehungsweise ihre Kritikalität zu analysieren und ihre weitere Verwendung festzulegen.

Ein erster Schritt 101 des Verfahrens umfasst eine Erfassung eines Impedanzspektrums des Batteriemoduls 1 mittels einer Impedanzspektroskopie. Bei dieser nicht-invasiven elektrochemischen Messtechnik wird ein Wechselstrom- und/oder Spannungssignal über einen bestimmten Frequenzbereich an dem Batteriemodul 1 angelegt und das daraus resultierende Impedanzspektrum (Impedanzantwort) des Batteriemoduls 1 erfasst. Das Impedanzspektrum stellt Informationen über verschiedene elektrochemische Prozesse innerhalb des Batteriemoduls, beispielsweise von Ladungsübertragungen, Diffusionen und/oder ohmschen Widerständen, bereit.

Gemäß der Impedanzspektroskopie umfasst der zweite Schritt 102 die Ermittlung eines DRT-Verlaufs mittels eines Verfahrens der verteilten Relaxationszeitkonstanten basierend auf dem erfassten Impedanzspektrum. Die DRT-Analyse ist eine Messtechnik, die darauf abzielt, verschiedene zeitabhängige Prozesse, die zur Impedanzantwort beitragen, aufzulösen und zu quantifizieren. Die DRT-Methode stellt somit detailliertere Einblicke in das Batterieverhalten und insbesondere Degradationsmechanismen im Vergleich zur einfachen, reinen Impedanzanalyse bereit.

In einem dritten Schritt 103 des Verfahrens wird ermittelt, ob das aktuell vorliegende Batteriemodul 1 kritisch ist. Dies erfolgt dadurch, dass ermittelt wird, ob der erfasste beziehungsweise ermittelte DRT-Verlauf einen vorab festgelegten Toleranzbereich verletzt. Der Toleranzbereich wird typischerweise durch eine obere und untere Kennlinie definiert. Durch den Toleranzbereich beziehungsweise die Kennlinien werden normale Schwankungen in der Batterieleistung berücksichtigen, während sie gleichzeitig empfindlich genug sind, um Anomalien zu erkennen, die auf eine Zelldegradation hinweisen.

Die Figur 1 zeigt eine zusätzliche Komponente, die eine Verwendung weiterer Daten/Informationen ermöglicht (Schritt 104), beispielsweise von Referenzmessungen, Parameter bezüglich des Batterietyps und historischer Daten. Diese Datenbank kann mit neuen Messungen und Analyseergebnissen aktualisiert werden, wodurch die Genauigkeit des Systems im Laufe der Zeit verbessert wird (Schritt 107).

Basierend auf der Analyse des Batteriemoduls 1 bezüglich seiner Kritikalität wird eine Verwendung beziehungsweise eine weitere Verwendung des Batteriemoduls ermittelt. Wird ermittelt, dass das Batteriemodul nicht-kritisch ist, kann es für eine Wiederverwendung 105 und/oder Wiederaufbereitung 105 verwendet werden (siehe J in der Figur 1). Dies könnte die Umnutzung des Batteriemoduls 1 für weniger anspruchsvolle Anwendungen und/oder die Wiederaufbereitung für die weitere Verwendung in ihrer ursprünglichen Anwendung umfassen. Wird ermittelt, dass das Batteriemodul 1 kritisch ist, kann es einem Recycling 106 zugeführt werden (siehe N in der Figur 1).

Weiterhin könnte die Messelektronik 101, 102 so konzipiert werden, dass sie mit verschiedenen Arten von Batteriemodulen kompatibel ist, was eine vielseitige Anwendung über verschiedene Batterietechnologien und Formfaktoren hinweg ermöglicht.

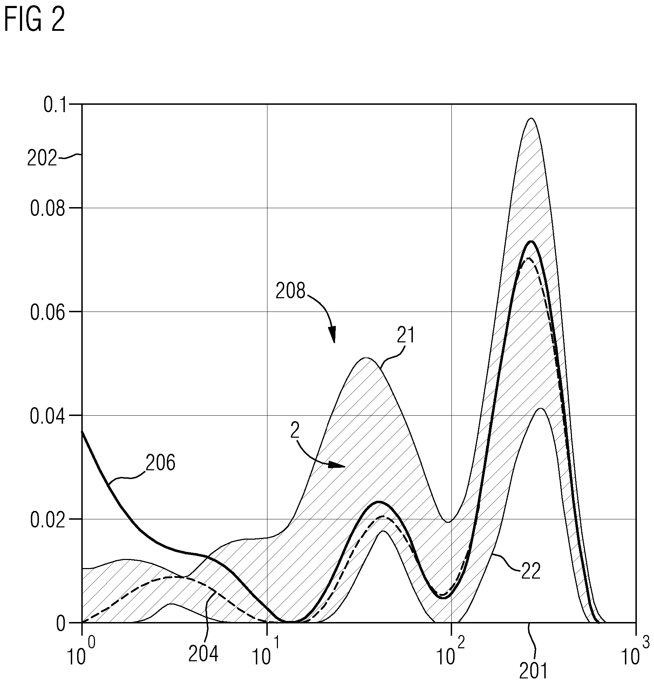

Figur 2 zeigt ein Diagramm, welches eine Analyse der Verteilung von Relaxationszeiten (DRT-Analyse) für ein Batteriemodul darstellt.

Das Diagramm weist eine Abszisse 201, die die Frequenz darstellt sowie eine Ordinate 202, die die DRT-Werte darstellt, auf.

Ein jeweiliger DRT-Verlauf 208 ist im Diagramm für ein nicht-kritisches Batteriemodul 204 sowie ein kritisches Batteriemodul 206 dargestellt.

Das Diagramm umfasst weiterhin eine obere Toleranzkennlinie 21 und eine untere Toleranzkennlinie 22, die zusammen einen Toleranzbereich 2 ausbilden. Die genannten Kennlinien 21, 22 beziehungsweise der Toleranzbereich 2 repräsentiert einen akzeptablen Bereich von DRT-Verläufen unter Berücksichtigung von normalen Toleranzen von Batteriemodulen. Hierbei werden insbesondere Fertigungstoleranzen und Leistungstoleranzen berücksichtigt.

Das Diagramm zeigt zwei DRT-Verläufe 204, 206. Einen nicht-kritischen DRT-Verlauf 204 sowie einen kritischen DRT-Verlauf 206. Der DRT-Verlauf 204 des nicht-kritischen Batteriemoduls 204 verbleibt über bestimmte Frequenzbereiche hinweg innerhalb des Toleranzbereichs 2. Dadurch wird ermittelbar, dass alle Zellen innerhalb des Batteriemoduls innerhalb akzeptabler Parameter funktionieren.

Der DRT-Verlauf des kritischen Batteriemoduls 206 (kritischer DRT-Verlauf) verletzt, insbesondere für niedrigere Frequenzen, den Toleranzbereich 2, das heißt, dass der DRT-Verlauf 206 wenigstens für bestimmte Frequenzen und/oder Frequenzbereiche außerhalb des Toleranzbereichs 2 liegt. Diese Verletzung/Abweichung zeigt an, dass das kritische Batteriemodul 206 mindestens eine Zelle mit einem Gesundheitszustand unter einem festgelegten Schwellenwert umfasst. Die Ermittlung der Abweichung bei niedrigeren Frequenzen ist besonders vorteilhaft, da diese typischerweise zu langsameren elektrochemischen Prozessen, wie beispielsweise Diffusion entspricht, die auf langfristige Degradationen und/oder Kapazitätsverluste hinweisen können. Mittels des DRT-Verlaufs könnte zusätzlich die Anzahl der kritischen Zellen das Batteriemodul ermittelt werden.

Das Diagramm veranschaulicht somit, wie das Verfahren kritische und nicht-kritischen Batteriemodule basierend auf ihren verschiedenen DRT-Verläufen ermitteln kann. Hierauf basierend kann die weitere Verwendung des Batteriemoduls bestimmt werden.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- 1: Batteriemodul
- 2: Toleranzbereich
- 21: obere Kennlinie
- 22: untere Kennlinie
- 101: erster Schritt
- 102: zweiter Schritt
- 103: dritter Schritt
- 104: zusätzliche Daten
- 105: Wiederverwendung oder Wiederaufbereitung
- 106: Recycling
- 107: zusätzliche Messungen
- 201: Abszisse
- 202: Ordinate
- 204: nicht-kritisches Batteriemodul
- 206: kritisches Batteriemodul
- 208: DRT-Verlauf

## Patentansprüche

1. Verfahren zur Ermittlung eines kritischen Batteriemoduls (1), wobei das Batteriemodul (1) kritisch ist, wenn es mindestens eine Batteriezelle mit einem Gesundheitszustand kleiner oder gleich einem festgelegten Schwellenwert umfasst, **gekennzeichnet durch** folgende Schritte:
- (101) Erfassen eines Impedanzspektrums des Batteriemoduls mittels einer Impedanzspektroskopie;
- (102) Ermitteln eines DRT-Verlaufs (208) mittels eines Verfahrens der verteilten Relaxationszeitkonstanten basierend auf dem erfassten Impedanzspektrum;
- (103) Ermitteln des Batteriemoduls (1) als kritisch, wenn der ermittelte DRT-Verlauf (208) einen festgelegten Toleranzbereich (2) verletzt.

2. Verfahren gemäß Anspruch 1, **dadurch gekennzeichnet, dass** ein Impedanzwert, insbesondere ein Impedanzwert oberhalb von 1 kHz, vom Impedanzspektrum subtrahiert wird.

3. Verfahren gemäß Anspruch 1 oder 2, **dadurch gekennzeichnet, dass** der Toleranzbereich (2) durch zwei Kennlinien (21, 22) begrenzt wird.

4. Verfahren gemäß einem der vorhergehenden Ansprüche, **dadurch gekennzeichnet, dass** das Impedanzspektrum wenigstens eine oder mehrere Frequenzen im Frequenzbereich von 10⁻³ Hz bis 10⁻² Hz und/oder von 1 bis 10 Hz und/oder von 100 Hz bis 1000 Hz umfasst.

5. Verfahren gemäß einem der vorhergehenden Ansprüche, **dadurch gekennzeichnet, dass** zur Ermittlung der Verletzung des Toleranzbereichs (2) der DRT-Verlauf (208) auf einen seiner Werte normiert wird.

6. Verfahren gemäß einem der vorhergehenden Ansprüche, **dadurch gekennzeichnet, dass** der Toleranzbereich (2) derart festgelegt wird, dass er Fertigungstoleranzen des Batteriemoduls (1) und/oder seiner Batteriezellen berücksichtigt.

7. Verfahren gemäß einem der vorhergehenden Ansprüche, **dadurch gekennzeichnet, dass** der Schwellenwert für den Gesundheitszustand der Batteriezellen auf einen Wert von 80 Prozent, vorzugsweise von 70 Prozent, besonders bevorzugt von 60 Prozent festgelegt wird.

8. Verwendung (105, 106) eines Batteriemoduls (1), die davon abhängt, ob das Batteriemodul (1) kritisch ist, wobei das Batteriemodul (1) kritisch ist, wenn es eine oder mehrere Batteriezellen mit einem Gesundheitszustand kleiner oder gleich einem festgelegten Schwellenwert umfasst, **dadurch gekennzeichnet, dass** die Ermittlung der Kritikalität des Batteriemoduls (1) mittels eines Verfahrens gemäß einem der vorhergehenden Ansprüche durchgeführt wird.

9. Verwendung gemäß Anspruch 8, **dadurch gekennzeichnet, dass** in Abhängigkeit von der Anzahl der Batteriezellen mit einem Gesundheitszustand kleiner oder gleich dem festgelegten Schwellenwert die Verwendung eine Wiederverwendung (105), eine Wiederaufbereitung (105) oder ein Recycling (106) des Batteriemoduls (1) ist.

10. Computerprogrammprodukt, umfassend Befehle, die, wenn sie von einer Recheneinheit, insbesondere einem Computer, ausgeführt werden, diese veranlassen, ein Verfahren und/oder Schritte des Verfahrens gemäß einem der Ansprüche 1 bis 9 auszuführen.
